# EUROPEAN PATENT APPLICATION

(11) **EP 4 567 904 A1**
(43) Date of publication of application: **11.06.2025**
(21) Application number: 23383248.4
(22) Date of filing: 04.12.2023
(51) Int. Cl.: H01L 31/054, H02S 20/30, H02S 20/32

(54) **PHOTOVOLTAIC MODULE FOR AGRICULTURAL INSTALLATIONS**

(71) Applicant: Proton New Energy Future, S.L., 08304 Mataró (Barcelona) (ES)
(72) Inventor: JOVÉ PERALTA, Miquel, 08304 MATARO (Barcelona) (ES)
(74) Representative: Herrero & Asociados, S.L.

(57) **Abstract**

The photovoltaic module for agricultural installations comprises a plurality of photovoltaic cells (5), a first frame (1) and a second frame (2) which is located above the first frame (1), the first frame (1) being movable relative to the second frame (2), the plurality of photovoltaic cells (5) being located in the first frame (1) and/or in the second frame (2).

It provides a photovoltaic module for agricultural installations that combines the needs for electricity production with the insolation needs of the plants underneath it.

## Description

### Object of the invention

The present invention refers to a photovoltaic module for agricultural installations, which is placed on the ground and is capable of coordinating the needs of electrical energy production with the insolation needs of the plants underneath it.

### Background to the invention

Today, there are many known photovoltaic systems for producing energy from sunlight.

Typically, these photovoltaic systems consist of modules placed on a surface, e.g. on the ground, and oriented to take advantage of sunlight.

Photovoltaic modules are also known to be mounted on mobile towers, e.g. with a central pedestal, which require an electric or hydraulic drive and permanent angular tracking systems.

In practice, it has been shown that these systems are not competitive in the photovoltaic market because they are much more expensive and much less reliable than conventional photovoltaic systems.

Although they can generate more electricity than conventional photovoltaic systems, this higher output does not compensate for their higher cost and maintenance requirements.

### Description of the invention

Therefore, one objective of the present invention is to provide a photovoltaic module for agricultural installations that allows coordinating the needs of electrical energy production with the insolation needs of the plants located underneath it.

With the photovoltaic module for agricultural installations of the invention, the aforementioned disadvantages are solved, presenting other advantages that will be described below.

The photovoltaic module for agricultural installations according to the present invention is described in claim 1, and the dependent claims include additional features that are optional.

In particular, the photovoltaic module for agricultural installations comprises:
- a first frame; and
- a second frame which is positioned above the first frame, the first frame being movable relative to the second frame,
wherein a plurality of photovoltaic cells is located in the first frame and/or in the second frame.

In this way, the photovoltaic module can be mounted on the ground, but without affecting the plants below it, and allowing the position of the first frame to be changed depending on the position of the sun.

Advantageously, the first frame is movable longitudinally and transversely with respect to the second frame, so that the module is always positioned perpendicular to the sun's rays.

Furthermore, the first frame and/or the second frame preferably comprise a plurality of focusing lenses in correspondence with the photovoltaic cells, which are, for example, made of methacrylate.

To prevent the inside of the photovoltaic module from getting dirty, the first and second frames are connected to each other by sealing gaskets, and are also connected to each other by movable connections, e.g. hinges that allow movement only about two axes.

Furthermore, the photovoltaic module for agricultural installations according to the present invention also comprises a tracking motor, which moves the first frame with respect to the second frame, the tracking motor preferably comprising two linear actuators.

The photovoltaic module also preferably comprises a solar sensor, which determines the movement of the first frame relative to the second frame depending on the position of the sun.

According to a preferred embodiment, each photocell is mounted on a photoreceptor, each photoreceptor comprising a heat diffuser and a reflector, and the first and second frames are made of aluminum, so that their weight is reduced.

The photovoltaic module according to the present invention provides at least the following advantages:
- It is lightweight;
- Provides transparency to reduce shadows;
- Optimizes the use of land for cultivation;
- It provides maximum energy efficiency at minimum cost to ensure commercial viability;
- Ensures that the focal point remains circular at all azimuth and elevation angles;
- Maintains maximum energy efficiency without overheating;
- Prevents fouling by ensuring it is watertight;
- It does not require emergency procedures to be established in case of high winds;
- Avoids loss of production in case of wind.

### Brief description of the drawings

For a better understanding of what has been explained above, some drawings are included in which, schematically and only by way of a non-limiting example, a practical case of embodiment is represented.

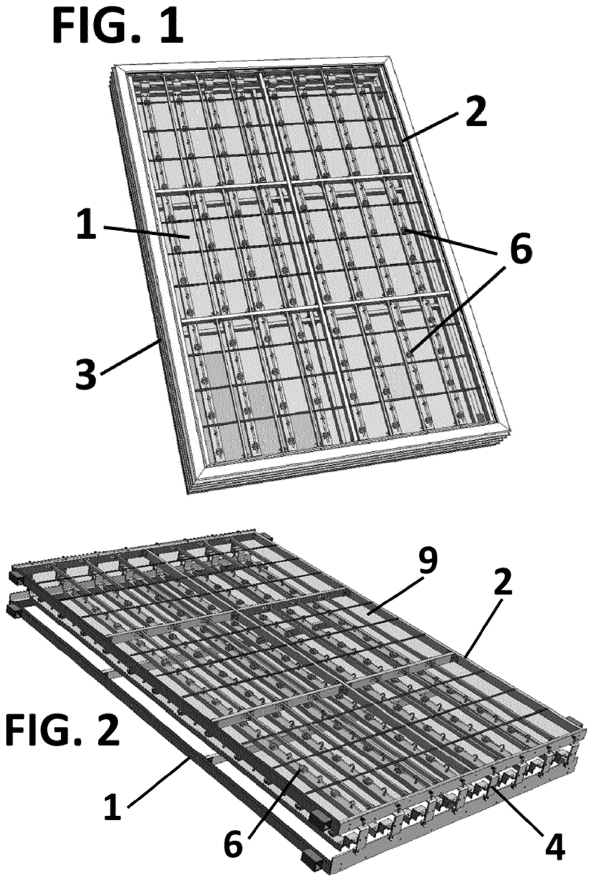

Figure 1 is a perspective view of the photovoltaic module according to the present invention;
Figure 2 is a perspective view of the photovoltaic module according to the present invention, with the first frame located in a first position with respect to the second frame;

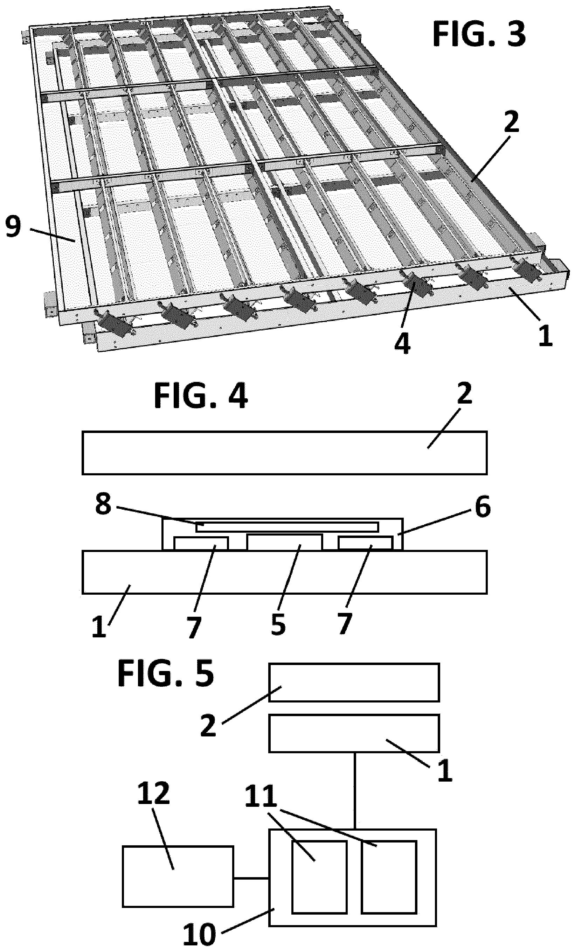

Figure 3 is a perspective view of the photovoltaic module according to the present invention, with the first frame located in a second position with respect to the second frame;
Figure 4 is a schematic cross-sectional elevation view of a part of the photovoltaic module according to the present invention, showing a photoreceptor mounted on the first frame; and
Figure 5 is a block diagram showing the connection of the motor and the solar sensor to the first frame of the photovoltaic module according to the present invention.

### Description of a preferred embodiment

The figures show the photovoltaic module according to the present invention, comprising a first frame 1 and a second frame 2, the second frame 2 being situated on the first frame 1 and the first frame 1 being movable with respect to the second frame 2.

In particular, the second frame 2 is positioned above the first frame 1, and the second frame 2 is fixed to the ground, for example, to the ground of an agricultural land.

In addition, the first frame 1 is movable with respect to the second frame 2 transversely and longitudinally, so that the module is always positioned perpendicular to the sun's rays.

The first and second frames 1, 2 are connected to each other by sealing gaskets 3 to prevent the inside of the module from getting dirty and by movable connections 4, e.g. hinges which only allow movement about two axes.

In order to be as light as possible, the first and second frames 1, 2 are preferably made of aluminum, but could be made of any other suitable material.

In the embodiment shown, the first frame 1 comprises a plurality of photovoltaic cells 5, although they could be located in the second frame 2, or in both frames 1, 2. Each of the photovoltaic cells 5 is located in a photoreceptor, indicated in general by the reference number 6, which also comprises heat diffusers 7 and reflectors 8.

For its part, according to the embodiment shown, the second frame 2 comprises a plurality of focusing lenses 9, for example, of methacrylate, in correspondence with the photovoltaic cells 5, although the focusing lenses 9 could also be located in the first frame 1, or in both frames 1, 2.

These concentrating lenses 9 capture the solar radiation and concentrate it on a focal point, corresponding to the photoelectric cells.

The photovoltaic module according to the present invention also comprises a tracking motor 10, which moves the first frame 1 with respect to the second frame 2. To enable transverse and longitudinal displacement of the first frame 1 with respect to the second frame 2, this tracking motor 10 comprises two linear actuators 11.

In addition, the tracking motor 10 moves the first frame 1 relative to the second frame 1 according to information provided by a sun sensor 12, which determines the position of the sun, as well as other information such as, for example, solar ephemeris equations.

In this way, a photovoltaic module is provided for agricultural installations that allows the coordination of the electrical energy production needs with the insolation needs of the plants located underneath it.

Although reference has been made to a specific embodiment of the invention, it is obvious to a person skilled in the art that the photovoltaic module for agricultural installations described is susceptible to numerous variations and modifications, and that all the details mentioned can be replaced by technically equivalent ones, without departing from the scope of protection defined by the appended claims.

## Claims

1. Photovoltaic module for agricultural installations, comprising a plurality of photovoltaic cells (5),
**characterized in that** it also comprises:
- a first frame (1); and
- a second frame (2) which is positioned over the first frame (1), the first frame (1) being movable relative to the second frame (2),
the plurality of photovoltaic cells (5) being located in the first frame (1) and/or in the second frame (2).

2. Photovoltaic module for agricultural installations according to claim 1, wherein the first frame (1) is movable longitudinally and transversely with respect to the second frame (2).

3. Photovoltaic module for agricultural installations according to claim 1 or 2, wherein the first frame (1) and/or the second frame (2) comprise a plurality of focusing lenses (9) in correspondence with the photovoltaic cells (5).

4. Photovoltaic module for agricultural installations according to any one of the preceding claims, wherein the focusing lenses (9) are made of methacrylate.

5. Photovoltaic module for agricultural installations according to any one of the preceding claims, wherein the first and second frames (1, 2) are joined together by sealing gaskets (3).

6. Photovoltaic module for agricultural installations according to any one of the preceding claims, wherein the first and second frames (1, 2) are connected to each other by means of movable connections (4).

7. Photovoltaic module for agricultural installations according to any one of the preceding claims, also comprising a tracking motor (10), which moves the first frame (1) with respect to the second frame (2).

8. Photovoltaic module for agricultural installations according to claim 7, wherein the tracking motor (10) comprises two linear actuators (11).

9. Photovoltaic module for agricultural installations according to any one of the previous claims, also comprising a solar sensor (12), which determines the movement of the first frame (1) with respect to the second frame (2) depending on the position of the sun.

10. Photovoltaic module for agricultural installations according to any one of the preceding claims, wherein each photocell (5) is mounted on a photoreceptor (6), each photoreceptor (6) comprising a heat diffuser (7) and a reflector (8).

11. Photovoltaic module for agricultural installations according to any one of the preceding claims, wherein the first and second frames (1, 2) are made of aluminum.

12. Photovoltaic module for agricultural installations according to claim 6, wherein the movable connections (4) are hinges that only allow movement with respect to two axes.
